(19) Europäisches Patentamt
European Patent Office
Office européen des brevets

(11) **EP 2 409 398 B1**

(12) **EUROPÄISCHE PATENTSCHRIFT**

(45) Veröffentlichungstag und Bekanntmachung des Hinweises auf die Patenterteilung:
**16.01.2013 Patentblatt 2013/03**

(21) Anmeldenummer: **10719721.2**

(22) Anmeldetag: **18.03.2010**

(51) Int Cl.:
*H02P 13/06* (2006.01)     *G05F 1/14* (2006.01)
*G05F 1/147* (2006.01)     *G06F 17/00* (2006.01)
*G06F 17/10* (2006.01)     *H01H 1/00* (2006.01)
*H01H 9/00* (2006.01)

(86) Internationale Anmeldenummer:
**PCT/DE2010/000292**

(87) Internationale Veröffentlichungsnummer:
**WO 2010/108473 (30.09.2010 Gazette 2010/39)**

(54) **EINRICHTUNG ZUR ÜBERWACHUNG VON STUFENSCHALTERN**

DEVICE FOR MONITORING STEP SWITCHES

DISPOSITIF POUR SURVEILLER DES COMMUTATEURS À GRADINS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **21.03.2009 DE 102009014333**

(43) Veröffentlichungstag der Anmeldung:
**25.01.2012 Patentblatt 2012/04**

(73) Patentinhaber: **A. Eberle GmbH & Co. KG**
**90461 Nürnberg (DE)**

(72) Erfinder:
• HAUSSEL, Werner
**90537 Feucht (DE)**
• MÜLLER, Mattias
**97616 Salz (DE)**
• WESTENDORF, Christian-Michael
**01277 Dresden (DE)**

(74) Vertreter: **Schuhmann, Albrecht**
**c/o Merten & Pfeffer**
**Allersberger Strasse 185**
**90461 Nürnberg (DE)**

(56) Entgegenhaltungen:
DE-A1- 10 119 664     DE-A1- 10 315 204
DE-A1- 10 318 191     DE-C1- 10 003 918
DE-C1- 19 907 834     US-A- 4 419 619
US-A- 5 428 551     US-A- 5 736 827
US-A1- 2004 215 402     US-A1- 2005 149 300

**Beschreibung**

Der Stufenschalter eines Stufentransformators ist das bestimmende Glied für die Zuverlässigkeit und Verfügbarkeit des Transformators in elektrischen Versorgungsnetzen. Deshalb ist es von hohem Nutzen, wenn der Stufenschalter überwacht wird, so dass Veränderungen am Stufenschalter rechtzeitig erkannt werden und vor einem Ausfall Wartungsmaßnahmen ergriffen werden können. Es erlaubt eine zustandsorientierte Instandhaltung und hilft dadurch Kosten zu sparen, weil die Instandhaltungsmaßnahmen nur dann ergriffen werden, wenn sie nötig sind.

Es gibt bereits derartige Einrichtungen, wie z. B. TAPGUARD 240 der Fa. Maschinenfabrik Reinhausen (siehe Bedienungsanleitung BA 244). Der wesentliche Nachteil dieser Einrichtung liegt darin, dass nur der Kontaktabbrand durch Messung der Kontaktströme überwacht wird. D.h., es werden nur die Kontaktabbrände als Kriterium für die Bewertung des tatsächlichen Betriebszustandes herangezogen.

Zudem müssen verschiedene Daten des Stufenschalters wie Typ, Überschaltwiderstände, Anzahl der parallelen Sektoren usw. werkseitig ganz spezifisch für den jeweilig zu überwachenden Stufenschalter parametriert werden. Dies impliziert, dass nur ganz bestimmte und vorbekannte Stufenschalter überwacht werden können, wie hier der zugehörige Stufenschalter der Fa. Maschinenfabrik Reinhausen.

Aus der Literatur werden noch weitere Größen für die Beurteilung des Betriebszustandes eines Stufenschalters genannt.

Eine der Größen ist der Motorstrom bzw. die Wirkleistung des Motorantriebs. Literaturstellen:

[1] A. Krämer, et. al.: "Monitoring Methods for Onload Tap-changers. An Overview and Future Perspectives" (CIGRE Session 1996, paper 12-108)

[2] S. Tenbohlen, et.al.: "Enhanced Diagnostic of Power Transformers using Onand Offline Methods: Results, Examples and Future trends" (CIGRE Session 2000, paper 12-204)

[3] S. Tenbohlen, et.al.: "Experienced-based Evaluation of Economic Benefits of On-line Monitoring Systems for Power Transformers" (CIGRE Session 2002, paper 12-110)

Diese Literaturstellen beziehen sich im Wesentlichen auf die Wirkleistung des Motors und bewerten den zeitlichen Ablauf und die Maxima verschiedener zeitlicher Abschnitte. Nachteil dieser Betrachtungsweise ist, dass nur sehr dramatische Fehler im Stufenschalter oder im Antrieb zu einer Aussage führen. Schleichende Vorgänge sind damit nicht zu detektieren.

Eine weitere Größe ist die Geräuschentwicklung während des Schaltvorgangs. Literaturstellen:

[4] Tord Bengtsson, et. al.: "Monitoring Tap Changer Operations" (CIGRE Session 1998, paper 12-209

[5] Tord Bengtsson, et. al.: "ACOUSTIC DIAGNOSIS OF TAP CHANGERS" (Contribution to Cigre 1996 session 32-INT-CANADA-12-1)

Diese Literaturstellen beschreiben sehr präzise wie die akustischen Signale der Schaltvorgänge aussehen [5]. Der in [4] beschriebene Algorithmus analysiert den zeitlichen Verlauf der Hüllkurve. Dadurch geht in nachteiliger Weise der Triggerzeitpunkt in die Bewertung ein. Zudem führt bei diesem Algorithmus ein sporadisch auftretender "konstanter" Geräuschpegel z. B. hervorgerufen durch Hagelschlag oder unterschiedliche lastabhängiges Vibrieren des Transformators zu Fehlwarnungen oder -alarmen.

Die Beurteilung der Funktion von Stufenschaltern ist zudem Gegenstand der Dokumente DE 10003918, US 4419619, DE 10119884, DE10315204.

Aufgabe der Erfindung ist es daher, möglichst viele Funktionsdaten eines Stufenschalters im Betrieb kontinuierlich zu erfassen und diese mit frei einlernbaren Referenzwerten zu vergleichen und Veränderungen und/oder Ausfälle an eine Signalverarbeitungseinheit zu melden, welche Anpassungen im Betrieb oder Warnmeldungen generieren kann.

Diese Aufgabe wird mit den Merkmalen des kennzeichnenden Teils des Anspruchs 1 gelöst. Fortbildungen und vorteilhafte Ausführungen der Erfindung sind in den weiteren Ansprüchen umfasst.

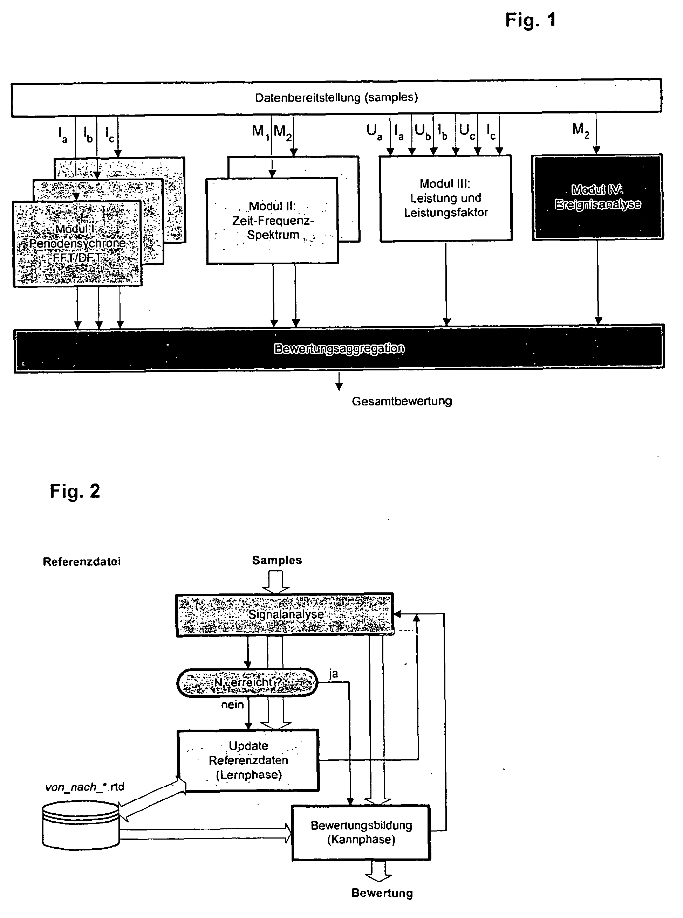

Der Erfindung liegt eine Einrichtung zugrunde, die alle oben genannten Daten wie Motorstrom $I_a$, $I_b$, $I_c$ und Motorspannung $U_a$, $U_b$, $U_c$, die Geräusche des Motors $M_1$ und die Geräusche des Stufenschalters $M_2$ sowie der Strom des Transformators $I_T$ parallel abtastet, bzw. abtasten kann (Abb. 1).

Erfindungsgemäß ist eine Einrichtung zur Überwachung von Stufenschaltern für insbesondere Transformatoren, durch Messung mindestens eines geeigneten Kontrollparameters wie Motorstrom, Motorspannung, Motorgeräusche, Temperatur und der Schaltgeräusche des Stufenschalters, wobei die Einrichtung über Mittel verfügt, mit welcher Start-Werte mindestens eines Kontrollparameters als Referenzwert hinterlegbar sind und weiter über Mittel verfügt um diese Werte mit aktuellen Betriebs-Ist Werten zu vergleichen und über Mittel verfügt, diese, daraus erzeugten Datensätze, einer Auswerteeinheit zuzuführen.

Ein zu verwendender Stufenschalter, dessen Funktion als geeignet erachtet wird, also frei von Defekten ist, kann somit mit der erfindungsgemäßen Einrichtung eingelernt werden, d.h. die Einrichtung erfasst in einem ersten Betrieb dieses Schalters, in welchem verschiedene Betriebszustände abgearbeitet werden, in einer Einlernphase die aktuellen Werte für verschiedene an dem Stufenschalter zu ermittelnde Werte, wie Motorstrom, Motorspannung, Motorgeräusche, Schaltgeräusche, sowie Temperatur u.a.

Diese ermittelten Werte werden in einer Speichereinheit der Einrichtung als Referenzwerte für diesen Stufenschalter hinterlegt. Durch mehrere solcher Einlernprozesse können diese Referenzen für unterschiedliche Betriebszustände und/oder Temperaturbereiche erfasst und hinterlegt werden, womit eine ständige Beurteilung der Werte des Stufenschalters möglich wird.

Je nach Einsatzbereich können einzelne Module zur Erfassung von Messdaten und Datensätzen zu oder abgeschaltet werden um auf wechselnde Anforderungen reagieren zu können.

Vorteil dieser Vorgehensweise ist, dass keine detaillierten Kenntnisse des Stufenschalters nötig sind, da der in der Lernphase erkannte Zustand über alle Messgrößen als Ausgangszustand für die weitere Bewertung dient. Nur Veränderungen gegenüber diesem Zustand werden bewertet und führen ggf. zu Warnungen oder Alarm. Dadurch können Stufenschalter jeder Bauart und jeden Alters überwacht werden.

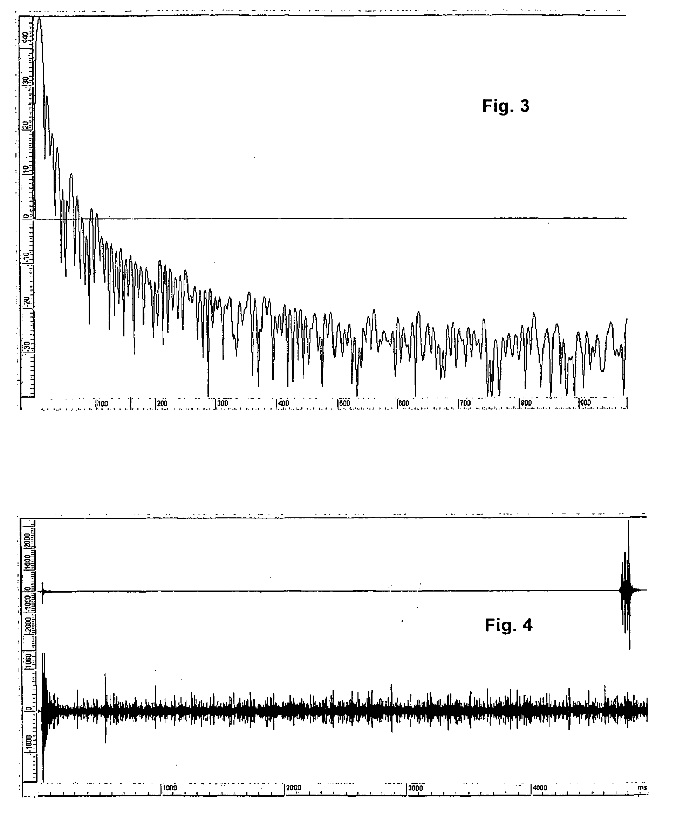

Eine weitere bevorzugte Ausführung sieht einen Zustand vor in welchem eine Spektralanalyse der einzelnen Phasen des Motorstroms $I_a$, $I_b$ und $I_c$ erfolgt. Alternativ können auch die Komponenten $I_d$ und $I_q$ des sog. PARK-Vektors spektral analysiert werden. Die Signalanalyse erfolgt periodensynchron mittels einer frei konfigurierbaren Diskreter Fourier-Transformation (DFT) oder einer Schnellen Fourier-Transformation (FFT). Ergebnis der Signalanalyse ist wahlweise ein Pegelspektrum (Abb. 3) oder ein Amplitudenspektrum.

Eine weitere Funktion sieht vor, dass davon ausgegangen, dass man mit dem Schwingungsaufnehmer bzw. Mikrofon M1 möglichst die Motorgeräusche erfasst, während das Erfassungsmittel M2 so angebracht wird, dass es praktisch nur das Schaltgeräusch aufnimmt (Abb. 3) und vom Motorengeräusch wenig beeinflusst wird. Dann kommt für M1 eine Frequenzanalyse in Betracht, während das Signal M2 mittels eines Ereignisdetektors analysiert wird.

Durch weitere Erfassungsmittel und Verarbeitungsmittel wird die Leistung und der Leistungsfaktor der drei Phasen a, b und c überwacht. Anhand der Perioden der Momentanleistung wird die Wirk- und Blindleistung sowie der Leistungsfaktor (cos $\varphi$) ermittelt.

Die Referenzbildung erfolgt in der Lernphase dadurch, dass eine Sequenz von Mittelwerten dieser Größen über eine einstellbare Periodenzahl gebildet wird, die den Verlauf der Wirkleistung und des Leistungsfaktors im Beobachtungszeitraum beschreibt. Die beobachtete Sequenz eines zu bewertenden Vorgangs wird dann mit dieser Referenzsequenz verglichen.

Im Folgenden wird die Erfindung anhand von Zeichnungen beispielhaft näher beschrieben, dabei zeigen:

Fig.1    zeigt ein Diagramm der Verarbeitung der Abtastwerte der Messdaten

Fig. 2    zeigt ein Diagramm der Lern- und Kannphase

Fig. 3    zeigt ein FFT-Spektrum einer einzelnen Periode.

Fig. 4    zeigt ein Spektrum der Mikrofon Signale M1 und M2

Fig. 5.    zeigt Beispiele der Enveloppe (Hüllkurve) des Schaltgeräusches

Fig. 6.    zeigt ein Diagramm der Gesamtbewertung

In Fig. 1 ist die Messung und Aufzeichnung der Größen zu sehen, welche durch das Einschaltsignal des Motors (Lauflampensignal) initiiert wird. Es entsteht ein Datensatz, der der Schalthandlung zugeordnet ist. Dabei werden alle Signale mit einer parametrierbaren Vorgeschichte aufgezeichnet. Dadurch können insbesondere bei den Geräuschen bereits vor dem Schaltvorgang vorliegende Störgeräusche berücksichtigt werden und führen nicht zu Fehlwarnungen und Fehlalarmen.

Die Datensätze werden hinsichtlich der zugehörigen Temperaturbereichs und des Stufenübergangs klassifiziert und in einer Matrix abgelegt. D.h., es wird die Umgebungstemperatur und/oder die Öltemperatur des Stufenschalters gemessen und die Stufenstellung des Stufenschalters aufgenommen.

Erfindungsgemäß wird die Verarbeitung der verschiedenen Signale bzw. der entsprechenden Datensätze durch verschiedene unabhängige Bausteine realisiert, die sich einzeln parametrieren bzw. auch abschalten lassen:

Modul I:    Periodensychrone Frequenzanalyse (FFT/DFT)
Modul II:    Zeit-Frequenz-Spektrum (FFT/DFT) oder Mittelwert-Spektrum
Modul III:    Leistung und Leistungsfaktor
Modul IV:    Ereignisanalyse

Die von den einzelnen Modulen gebildeten numerischen Bewertungen des aktuellen Datensatzes werden im Modul Bewertungsaggregation zu einer einzigen numerischen Bewertung zusammengefasst, die wiederum die Basis für die Entscheidung über einen möglichen Fehler darstellt.

Die Bewertung, die durch die einzelnen Module gebildet wird, basiert auf einem Vergleich der aktuellen Daten mit zuvor gespeicherten **Referenzdaten**. Diese Referenzdaten werden in einer **Lernphase** gebildet, die je nach Modul auch unterschiedlich lang sein kann. Jeder Modul entscheidet autonom anhand der vorgegebenen Kriterien, ob der Modul sich noch in der Lernphase bzw. ob der Modul sich in der Kannphase befindet.

Abb. 2 zeigt die Lern- und Kannphase. $N_L$ ist die Anzahl der in der Lernphase verarbeiteten Datensätze

Die in der Lernphase verarbeiteten Datensätze werden als **korrekt** und **typisch** vorausgesetzt.

Vorteil dieser Vorgehensweise ist, dass keine detaillierten Kenntnisse des Stufenschalters nötig sind, da der in der Lernphase erkannte Zustand über alle Messgrößen als Ausgangszustand für die weitere Bewertung dient. Nur Veränderungen gegenüber diesem Zustand werden bewertet und führen ggf. zu Warnungen oder Alarm. Dadurch können Stufenschalter jeder Bauart und jeden Alters überwacht werden.

*Modul I: Spektralanalyse der Stromkomponenten*

Dieser Modul ermöglicht erfindungsgemäß eine Spektralanalyse der einzelnen Phasen des Motorstroms $I_a$, $I_b$ und $I_c$. Alternativ können auch die Komponenten $I_d$ und $I_q$ des sog. PARK-Vektors spektral analysiert werden. Die Signalanalyse erfolgt **periodensynchron** mittels einer frei konfigurierbaren Diskreter Fourier-Transformation (**DFT**) oder einer Schnellen Fourier-Transformation (**FFT**). Ergebnis der Signalanalyse ist wahlweise ein **Pegelspektrum** (Abb. 3) oder ein **Amplitudenspektrum.**

Zur Bildung von Merkmalvektoren mit statistisch unabhängigen Komponenten und reduzierter Komponentenanzahl (im Vergleich zur Komponentenanzahl des Original-Spektrums) wird eine **Hauptachsentransformation** eingesetzt, deren Parameter in einer ersten Phase des Trainings berechnet werden.

Ist die Hauptachsentransformation bekannt, wird in der zweiten Phase des Trainings eine **Clustermenge** berechnet, deren einzelne Cluster in der Arbeitsphase als Prototypen zur Berechnung der Bewertung unbekannter Merkmalvektoren benutzt werden (**Distanzen**).

Hauptachsentransformation und Clusterbildung kann man als Methoden zur Komprimierung der im Signal enthaltenen Information ansehen, bei der wesentliche Charakteristika des Signals erhalten bleiben.

Im Ergebnis der Kannphase werden der **Mittelwert** und die **Streuung** der Abstände der Merkmalvektoren zum jeweils am besten passenden Prototyp ausgegeben.

Ein FFT-Spektrum einer einzelnen Periode ist in Fig. 3 zu sehen.

X-Achse: Frequenzlinien; y-Achse: Pegel [dB]; Frequenz von 0 ... 6000 Hz; Auflösung 6.1035 Hz; FFT-Länge: 2048 samples; Abtastfrequenz/Resampling 50 kHz/4

*Modul II: Spektralanalyse der Mikrofonkanäle*

Es wird davon ausgegangen, dass man mit dem Schwingungsaufnehmer bzw. Mikrofon M1 möglichst die **Motorgeräusche** erfasst, während M2 so angebracht wird, dass es praktisch nur das **Schaltgeräusch** aufnimmt (Abb. 3) und vom Motorengeräusch wenig beeinflusst wird. Dann kommt für M1 eine Frequenzanalyse in Betracht, während das Signal M2 mittels eines Ereignisdetektors analysiert wird (vgl. Modul IV)

In Fig. 4 sind die Kurven der Mikrofon-Signale M1 (unten) und M2 (oben) aufgezeigt.

Die Implementierung der Spektralanalyse entspricht der von Modul I, jedoch mit einem Zeitfenster konstanter Länge (keine sinnvolle Periodensuche möglich). Die Frequenzanalyse, die Hauptachsentransformation und die Bildung bzw. Auswertung der Clusterbasis wird wie im Modul I vorgenommen. Die Ereignisdetektion und -bewertung ist im Modul IV implementiert (s. unten).

*Modul III: Überwachung der Leistung und des Leistungsfaktors*

Dieser Modul überwacht die **Leistung** und den **Leistungsfaktor** der drei Phasen a, b und c. Anhand der Perioden der Momentanleistung wird die Wirk- und Blindleistung sowie der Leistungsfaktor (cos φ) ermittelt.

Die Referenzbildung erfolgt in der Lernphase dadurch, dass eine Sequenz von Mittelwerten dieser Größen über eine einstellbare Periodenzahl gebildet wird, die den Verlauf der Wirkleistung und des Leistungsfaktors im Beobachtungszeitraum beschreibt. Die beobachtete Sequenz eines zu bewertenden Vorgangs wird dann mit dieser Referenzsequenz verglichen.

*Modul IV: Ereignisorientierte Analyse*

Modul IV sucht anhand eines Schwellwertes ein **akustisches Ereignis**, das von einem Schaltvorgang des Tap Changers stammt. Dieses Ereignis kann entweder im **Zeitbereich** oder im **Spektralbereich** mit entsprechend angelernten Mustern verglichen werden.

Beim Mustervergleich im Zeitbereich wird die **Hüllkurve** des gleichgerichteten Signals ermittelt. Das Ereignis selbst wird mittels eines Schwellwert-Verfahrens in einem eingegrenzten Zeitbereich gesucht.

Die in der Lernphase erhobenen Muster werden so zeitverschoben, dass sie möglichst gut "passen" (im Sinne einer **Korrelationsfunktion**). Aus diesen Mustern werden Mittelwert und Streuung der Zeitfunktion berechnet.

Neue Muster werden mit dem mittleren Muster verglichen, wobei eine numerische Bewertung bestimmt und ausgegeben wird.

Alternativ zum Vergleich im Zeitbereich wird erfindungsgemäß auch eine **Spektralanalyse** des Vorgangs durchgeführt (Berechnung von Pegelspektren). Der Vergleich findet dann zwischen dem aktuellen und dem Referenzspektrum statt.

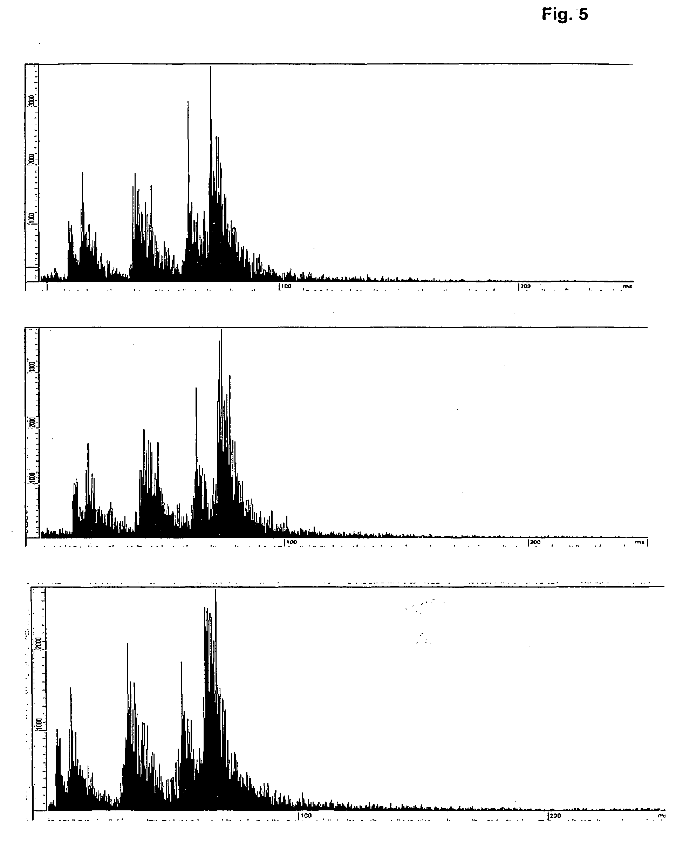

In der Fig. 5 sind Beispiele der Enveloppe (Hüllkurve) des Schaltgeräuschs des Stufenschalters gezeigt.

*Bewertungsaggregation*

Die einzelnen Module tragen ihre jeweiligen Bewertungen in einen Speicher (,Blackboard') ein. Die aus verschiedenen Modulen stammenden Bewertungen können aber nicht ohne weiteres zusammengefasst werden, da sie unterschiedlich skaliert sind, insbesondere in unterschiedlicher Weise streuen.

Aus diesem Grunde ist es notwendig, Standardabweichungen und Mittelwerte der lokalen Bewertungen zu ermitteln. Dies stellt einen weiteren Lernschritt dar, der dann beginnt, wenn Bewertungen berechnet werden können, d.h. nach Abschluss des primären Trainings.

Die **normierten Bewertungen** $g_i$ ergeben sich durch eine Standardisierung:

$$g_i' = c\,(g_i - \mu_i)\,/\,s_i$$

$g_i'$ - normierte Bewertung
$g_i$ - Rohbewertung aus Modul i
$\mu_i$ - Mittelwert der Rohbewertungen des Moduls i
$s_i$ - Standardabweichung der Rohbewertungen des Moduls i
$c$ - Korrekturfaktor wegen Unterschätzung der Streuung

Um zu einer einheitlichen Aussage - Bewertung - für einen Datensatz zu kommen, wird erfindungsgemäß eine **Aggregation** der normierten Bewertungen g' auf folgende Weise durchgeführt:

1. Mittelwert
2. Median
3. worst case (Maximum)
4. 2nd worst case

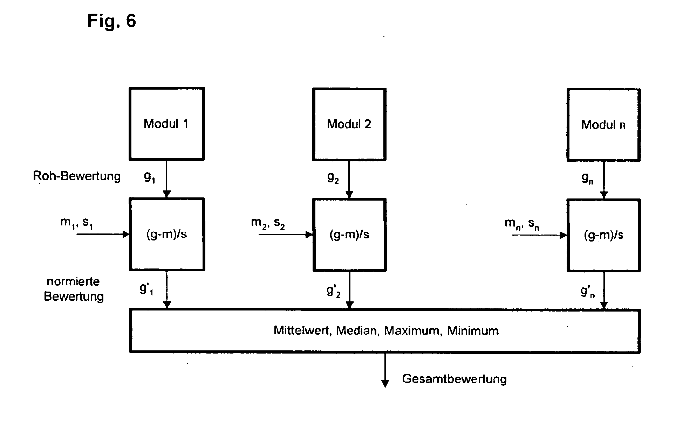

Die Ergebnisse der Bewertungsaggregation werden in eine ASCII-Datei ausgegeben, die vom übergeordneten System eingelesen und ausgewertet wird, wie in der Fig. 6 zu sehen ist.

Nachdem bevorzugte Ausführungen der Erfindung in Bezug auf die beiliegenden Zeichnungen beschrieben wurden, ist festzuhalten, dass die Erfindung nicht auf diese genauen Ausführungen beschränkt ist und dass verschiedene Änderungen und Modifizierungen daran von einem Fachmann ausgeführt werden können, ohne dass vom Umfang der Erfindung, wie er in den beiliegenden Ansprüchen definiert ist abgewichen wird.

## Patentansprüche

1. Einrichtung zur Überwachung von Stufenschaltern für insbesondere Transformatoren, durch Messung mindestens eines geeigneten Kontrollparameters wie Motorstrom, Motorspannung, Motorgeräusche, Temperatur und der Schaltgeräusche des Stufenschalters
**dadurch gekennzeichnet,**
**dass** die Einrichtung über Mittel verfügt, mit welcher aus Start-Werten mindestens eines Kontrollparameters Hüllkurven oder Pegelspektren erzeugt werden und diese in einer Lernphase als Referenzwert hinterlegbar sind und weiter über Mittel verfügt, um diese Werte mit aktuellen Betriebs-Ist Werten zu vergleichen, und über Mittel verfügt, diese, daraus erzeugten Datensätze, einer Auswerteeinheit zuzuführen.

2. Einrichtung zur Überwachung von Stufenschaltern gemäß Anspruch 1
**dadurch gekennzeichnet,**
**dass** die Einrichtung zur Verarbeitung der verschiedenen Signale der Datensätze mit verschiedenen, unabhängigen, Bausteinen (Modulen) realisiert ist, die einzeln parametrierbar bzw. auch abschaltbar ausgeführt sind

3. Einrichtung zur Überwachung von Stufenschaltern gemäß Anspruch 1 bis 2
**dadurch gekennzeichnet,**
**dass** mit einem Modul I eine periodensynchrone Spektralanalyse der Strom- und Spannungskomponente erfolgt, und dass mittels einer zuvor gelernten Hauptachsentransformation daraus Merkmalvektoren gebildet werden, die in Form von Clustern als Referenz hinterlegt sind.

4. Einrichtung zur Überwachung von Stufenschaltern gemäß Anspruch 1 bis 2
**dadurch gekennzeichnet,**
**dass** mit einem Modul II eine Spektralanalyse des Mikrofonkanals mit gleitendem Zeitfenster konstanter Länge erfolgt, und dass mittels einer zuvor gelernten Hauptachsentransformation daraus Merkmalvektoren gebildet werden, die in Form von Clustern als Referenz abgelegt sind.

5. Einrichtung zur Überwachung von Stufenschaltern gemäß Anspruch 4
**dadurch gekennzeichnet,**
**dass** bei der Auswertung der Geräusche in Modul II die Vorgeschichte der Signale korrigierend berücksichtigt ist.

6. Einrichtung zur Überwachung von Stufenschaltern gemäß Anspruch 1 bis 2
**dadurch gekennzeichnet,**
**dass** mit einem Modul III für jede Strom- und Spannungskomponente die Wirk- und Scheinleistung sowie der Leistungsfaktor periodensynchron berechnet ist.

7. Einrichtung zur Überwachung von Stufenschaltern gemäß Anspruch 1 bis 2 und 4 **dadurch gekenn-**

zeichnet,

**dass** mit einem Modul IV welches in dem Mikrofonsignal des Schaltgeräuschs (M2) nach dem Knackgeräusch des Stufenschalters sucht, eine Hüllkurve des Signals gebildet wird, und dass diese Hüllkurve mit den in der Lernphase abgelegten Musterhüllkurven durch Korrelation verglichen wird, oder dass anstelle der Hüllkurve das Pegelspektrum des Knackgeräuschs bestimmt und mit entsprechenden Musterspektren verglichen wird.

8. Einrichtung zur Überwachung von Stufenschaltern gemäß Anspruch 1 bis 7
   **dadurch gekennzeichnet,**
   **dass** die Bewertung pro Modul hinsichtlich Mittelwert, Median, worst case (Maximum) und. 2nd worst case erfolgt.

9. Einrichtung zur Überwachung von Stufenschaltern gemäß Anspruch 1 bis 8
   **dadurch gekennzeichnet,**
   **dass** in einer Lernphase für jedes Modul eigene, nach Temperaturklassen und Stufenübergängen klassifizierte Referenzdaten angelegt werden

10. Einrichtung zur Überwachung von Stufenschaltern gemäß Anspruch 1 bis 9
    **dadurch gekennzeichnet,**
    **dass** die Anzahl der für die Lernphase notwendigen Datensätze parametrierbar ist.

11. Einrichtung zur Überwachung von Stufenschaltern gemäß Anspruch 1 bis 10
    **dadurch gekennzeichnet,**
    **dass** die bei der Auswertung eines aktuellen Datensatzes entstehenden Daten zur Bewertung der Schalthandlung mit den Referenzdaten verglichen werden.

12. Einrichtung zur Überwachung von Stufenschaltern gemäß Anspruch 1 bis 11
    **dadurch gekennzeichnet,**
    **dass** die Ergebnisse der Bewertung durch geeignete Gewichtung der Einzelergebnisse der Module zu einer Gesamtbewertung zusammengefasst wird.

13. Einrichtung zur Überwachung von Stufenschaltern gemäß Anspruch 12
    **dadurch gekennzeichnet,**
    **dass** die Gesamtbewertung durch Schwellwertbildung als einer Vorwarnung, Warnung oder als Alarm ausgegeben wird.

**Claims**

1. Arrangement for monitoring on-load tap changers, especially for transformers, by measuring at least one suitable control parameter such as motor current, motor voltage, motor noise, temperature and switching noise of the on-load tap changer,
   **characterized in that**
   the arrangement includes means by which from the starting values of at least one control parameter, envelope curves or level spectra are generated which can be attributed as reference values to a learning phase, and also means to compare these values with actual current operating values, and means to assign the resulting datasets to an evaluation unit.

2. Arrangement for monitoring on-load tap changers according to Claim 1,
   **characterized in that**
   the arrangement for processing the various signals of the datasets is accomplished with various independent components (modules) which are individually parametrizable and also disconnectable.

3. Arrangement for monitoring on-load tap changers according to Claims 1 and 2,
   **characterized in that**
   a module I is used for a period-synchronous spectral analysis of the current and voltage component, and that by means of a previously learned main-axis transformation, feature vectors are formed from this, which are stored as reference in the form of clusters.

4. Arrangement for monitoring on-load tap changers according to Claims 1 to 2,
   **characterized in that**
   a module II is used for a spectral analysis of the microphone channel with a sliding time window of constant length, and that by means of a previously learned main-axis transformation, feature vectors are formed from this, which are stored as reference in the form of clusters.

5. Arrangement for monitoring on-load tap changers according to Claim 4,
   **characterized in that**
   in the evaluation of noises in module II, the prehistory of the signal is taken into consideration as a corrective factor.

6. Arrangement for monitoring on-load tap changers according to Claims 1 to 2,
   **characterized in that**
   a module III is used for a period-synchronous calculation of the effective power and the apparent power as well as the efficiency factor.

7. Arrangement for monitoring on-load tap changers according to Claims 1 to 2 and Claim 4,
   **characterized in that**
   a module IV, which is detecting the clicking sound of the on-load tap changer, is used to form an envelope curve of the signal, and that this envelope curve is compared by means of correlation with the model envelope curves stored in the learning phase, or that instead of the envelope curve, the level spectrum of the clicking sound is determined and compared with corresponding sample spectra.

8. Arrangement for monitoring on-load tap changers according to Claims 1 to 7,
   **characterized in that**
   the evaluation is done per module in terms of mean value, median, worst case (maximum) and 2nd worst case.

9. Arrangement for monitoring on-load tap changers according to Claims 1 to 8,
   **characterized in that**
   in a learning phase, reference data classified by temperature classes and step transitions are prepared separately for each module.

10. Arrangement for monitoring on-load tap changers according to Claims 1 to 9,
    **characterized in that**
    the number of datasets necessary for the learning phase is parametrizable.

11. Arrangement for monitoring on-load tap changers according to Claims 1 to 10,
    **characterized in that**
    the data resulting from the evaluation of a current dataset are compared with the reference data to evaluate the switching operation.

12. Arrangement for monitoring on-load tap changers according to Claims 1 to 11,
    **characterized in that**
    the results of the evaluation are combined into an overall evaluation by means of weighting the individual results of the modules.

13. Arrangement for monitoring on-load tap changers according to Claim 12,
    **characterized in that**
    by forming a threshold value, the overall evaluation is released as a pre-warning, warning or alarm.

## Revendications

1. Dispositif destiné au contrôle des commutateurs à prises de réglage, en particulier pour des transformateurs, par la mesure d'au moins un paramètre de contrôle approprié comme le courant de moteur, la tension de moteur, le bruit de moteur, la température et les bruits de commutation du commutateur à prises de réglage **caractérisé en ce que** le dispositif dispose de moyens avec lesquels à partir de valeurs initiales d'au moins un paramètre de contrôle sont produites des enveloppantes ou des spectres de niveau et **en ce que** ceux-ci peuvent être mémorisés au cours d'une phase d'apprentissage en tant que valeurs de référence et dispose en plus de moyens pour comparer ces valeurs à des valeurs réelles de fonctionnement actuelles et dispose de moyens pour attribuer ces ensembles de données produits à partir de celles-ci à une unité d'exploitation.

2. Dispositif destiné au contrôle des commutateurs à prises de réglage selon la revendication 1 **caractérisé en ce que** le dispositif pour le traitement des différents signaux des ensembles de données est réalisé avec des composants (modules) différents, indépendants qui sont élaborés séparément paramétrables ou également déconnectables.

3. Dispositif destiné au contrôle des commutateurs à prises de réglage selon les revendications 1 à 2 **caractérisé en ce qu'**une analyse spectrale synchrone en période des composants de courant et de tension a lieu avec un module I et **en ce qu'**au moyen d'une transformation d'axe principal préalablement apprise des vecteurs caractéristiques sont formés à partir de celle-ci, qui sont mémorisés en tant que référence sous la forme de grappes.

4. Dispositif destiné au contrôle des commutateurs à prises de réglage selon les revendications 1 à 2 **caractérisé en ce qu'**une analyse spectrale du canal de microphone avec une fenêtre de temps variable de longueur constante a lieu avec un module II et **en ce qu'**au moyen d'une transformation d'axe principal préalablement apprise des vecteurs caractéristiques sont formés à partir de celle-ci qui sont mémorisés en tant que référence sous la forme de grappes.

5. Dispositif destiné au contrôle des commutateurs à prises de réglage selon la revendication 4 **caractérisé en ce que** lors de l'évaluation des bruits dans le module II, l'historique des signaux est pris en considération de façon corrective.

6. Dispositif destiné au contrôle des commutateurs à prises de réglage selon les revendications 1 à 2 **caractérisé en ce que** pour chaque composant de courant et de tension la puissance effective et apparente ainsi que le facteur de puissance sont calculés avec un module III de façon synchrone en période.

7. Dispositif destiné au contrôle des commutateurs à prises de réglage selon les revendications 1 à 2 et 4 **caractérisé en ce qu'**avec un module IV qui recherche les grésillements du commutateur à prises de réglage dans le signal de microphone du bruit de commutation (M2), on constitue une enveloppante du signal et **en ce que** cette enveloppante est comparée par corrélation aux enveloppantes échantillons mémorisées au cours de la phase d'apprentissage ou **en ce qu'**à la place de l'enveloppante, le spectre de niveau de grésillement est déterminé et comparé aux spectres échantillons correspondants.

8.  Dispositif destiné au contrôle des commutateurs à prises de réglage selon les revendications 1 à 7 **caractérisé en ce que** l'évaluation par module a lieu en ce qui concerne la moyenne, la médiane, le cas le plus défavorable (maximum) et le deuxième cas le plus défavorable.

9.  Dispositif destiné au contrôle des commutateurs à prises de réglage selon les revendications 1 à 8 **caractérisé en ce que** dans une phase d'apprentissage, des données de références propres, classées selon les catégories de température et de passages de phase, sont établies pour chaque module.

10. Dispositif destiné au contrôle des commutateurs à prises de réglage selon les revendications 1 à 9 **caractérisé en ce que** le nombre des ensembles de données nécessaires à la phase d'apprentissage est paramétrable.

11. Dispositif destiné au contrôle des commutateurs à prises de réglage selon les revendications 1 à 10 **caractérisé en ce que** les données apparaissant lors de l'exploitation d'un ensemble de données réel sont comparées aux données de référence pour évaluer l'opération de commutation.

12. Dispositif destiné au contrôle des commutateurs à prises de réglage selon les revendications 1 à 11 **caractérisé en ce que** les résultats de l'évaluation sont résumés en une évaluation globale par pondération appropriée des résultats individuels des modules.

13. Dispositif destiné au contrôle des commutateurs à prises de réglage selon la revendication 12 **caractérisé en ce que** l'évaluation globale est sortie par la constitution d'une valeur de seuil sous la forme d'un avertissement préalable, d'un avertissement ou d'une alarme.

## Fig. 1

Datenbereitstellung (samples)

$I_a$ $I_b$ $I_c$          $M_1$ $M_2$          $U_a$ $I_a$ $U_b$ $I_b$ $U_c$ $I_c$          $M_2$

Modul I:
Periodensychrone
FFT/DFT

Modul II:
Zeit-Frequenz-
Spektrum

Modul III:
Leistung und
Leistungsfaktor

Modul IV:
Ereignisanalyse

Bewertungsaggregation

Gesamtbewertung

## Fig. 2

Referenzdatei          Samples

Signalanalyse

N erreicht?          ja

nein

Update
Referenzdaten
(Lernphase)

von_nach_*.rtd

Bewertungsbildung
(Kannphase)

Bewertung

Fig. 3

Fig. 4

**Fig. 5**

EP 2 409 398 B1

Fig. 6

| Modul 1 | | Modul 2 | | | Modul n |

Roh-Bewertung $g_1$ $g_2$ $g_n$

$m_1, s_1$ → (g-m)/s $m_2, s_2$ → (g-m)/s $m_n, s_n$ → (g-m)/s

normierte
Bewertung $g'_1$ $g'_2$ $g'_n$

Mittelwert, Median, Maximum, Minimum

↓ Gesamtbewertung

**IN DER BESCHREIBUNG AUFGEFÜHRTE DOKUMENTE**

**In der Beschreibung aufgeführte Patentdokumente**

- DE 10003918
- US 4419619 A
- DE 10119884
- DE 10315204


**In der Beschreibung aufgeführte Nicht-Patentliteratur**

- **A. KRÄMER.** Monitoring Methods for On-load Tap-changers. An Overview and Future Perspectives. *CIGRE Session,* 1996
- **S. TENBOHLEN.** Enhanced Diagnostic of Power Transformers using Onand Offline Methods: Results, Examples and Future trends. *CIGRE Session 2000,* 2000
- **S. TENBOHLEN.** Experienced-based Evaluation of Economic Benefits of On-line Monitoring Systems for Power Transformers. *CIGRE Session,* 2002
- **TORD BENGTSSON.** Monitoring Tap Changer Operations. *CIGRE Session,* 1998
- **TORD BENGTSSON.** ACOUSTIC DIAGNOSIS OF TAP CHANGERS. *Contribution to Cigre 1996 session 32-INT-CANADA-12-1,* 1996